# FASCICULE DE BREVET EUROPEEN

(11) **EP 2 246 890 B1**
(45) Date de publication et mention de la délivrance du brevet: **13.03.2013**
(21) Numéro de dépôt: 10161023.6
(22) Date de dépôt: 26.04.2010
(51) Int. Cl.: H01L 27/146

(54) **Mode de réalisation d'un module de capture d'images**
Herstellungsmethode eines Bildgebermoduls
Method of fabrication of an imager module

(30) Priorité: 28.04.2009 FR 0952790
(43) Date de publication de la demande: 03.11.2010
(73) Titulaire: STMicroelectronics (Crolles 2) SAS, 38920 Crolles (FR)
(72) Inventeur: Gagnard, Xavier, 38450, VIF (FR)
(74) Mandataire: de Beaumont, Michel

(56) Documents cités:
- EP-A- 1 387 397
- JP-A- 2002 329 850
- US-A1- 2002 135 069
- US-A1- 2006 043 262

## Description

### Domaine de l'invention

La présente invention concerne la réalisation des modules de capture d'images.

De tels modules sont particulièrement adaptés à des équipements nomades comme les téléphones portables, les ordinateurs portables, les caméras vidéo.

### Exposé de l'art antérieur

US2006/043262 A1 décrit un procédé de réalisation de modules de capture d'images. Une première tranche comportant sur une première face des capteurs d'images et une deuxième tranche comportant sur une première face des cavités borgnes entourées de murs sont réalisées. La deuxième tranche est gravée jusqu'à ouvrir le fond des cavités pour former des ouvertures. Ensuite, lesdites premières faces des première et deuxième tranches sont accolées.

US2002/135069 A1 décrit un procédé de réalisation des passages conducteurs dans une tranche. Les passages conducteurs sont réalisées à une certaine profondeur sous une première face de cette tranche sans la traverser. Ensuite, cette tranche est érodée à partir de sa seconde face jusqu'à atteindre les passages conducteurs.

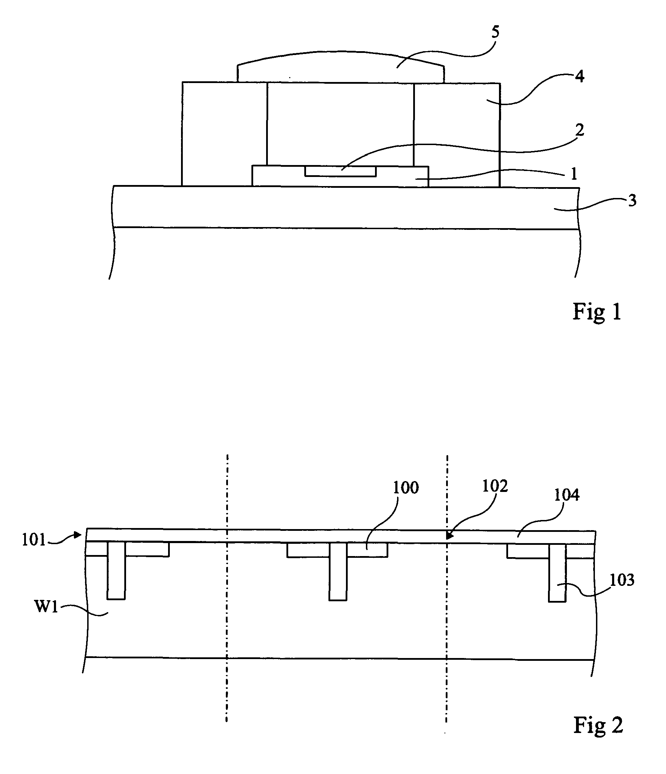

La figure 1 illustre un module de capture d'images selon l'art antérieur. Une puce de circuit intégré 1 comporte en sa surface un capteur d'image 2. La puce est collée sur un circuit imprimé 3 et est connectée électriquement à ce circuit imprimé par des fils métalliques conducteurs. Un mur 4 entoure le boîtier au-delà du contour de la puce. Ce mur est réalisé en résine moulée. Une lentille 5 repose sur la partie supérieure du mur. La hauteur du mur est ajustée, par des moyens non représentés, de façon que le plan focal de la lentille soit au niveau du capteur d'images.

L'ensemble ainsi constitué forme un module de capture d'images soudé sur un circuit imprimé 3. La lentille est apte à focaliser l'image d'un objet externe éclairé sur la puce de circuit intégré.

La réalisation d'un tel module nécessite de multiples opérations comme le montage du circuit intégré sur le circuit imprimé, le moulage du mur, le collage de la lentille, l'ajustement de la distance de la lentille à la puce de circuit intégré.

La fiabilité de l'ensemble dépend de la qualité du montage du circuit intégré dans le boîtier, de la soudure de ce boîtier sur le circuit imprimé, et de la qualité du montage de la lentille au dessus du boîtier.

La distance de la lentille à la puce de circuit intégré doit être de quelques millimètres avec une précision de 10 micromètres, précision qui nécessite un ajustement spécifique sur chaque module.

La surface occupée par le module de prise de vue est nettement plus importante que la surface de la puce.

Le test électrique fonctionnel du module de capture d'images est effectué après la découpe du circuit intégré et le montage sur le circuit imprimé 3.

### Résumé

Un objet d'un mode de réalisation de la présente invention est de prévoir un procédé de réalisation de modules de capture d'images fiable et peu coûteux à réaliser.

Un autre objet d'un mode de réalisation de la présente invention est de prévoir un procédé de réalisation permettant un contrôle précis de la distance puce-lentille sans nécessiter une étape d'ajustement de cette distance.

Un autre objet d'un mode de réalisation de la présente invention est de réaliser un module de capture d'images de faible surface et de faible hauteur.

Un autre objet d'un mode de réalisation de la présente invention est de pouvoir tester la fonctionnalité des modules de capture d'images situés sur une même tranche, avant découpe.

Un mode de réalisation de la présente invention prévoit un procédé de réalisation de modules de capture d'images selon la revendication 1.

Selon un mode de réalisation de la présente invention, le capteur d'images est réalisé avec des transistors MOS.

Selon un mode de réalisation de la présente invention, les passages conducteurs s'étendent à une profondeur de 50 à 300 µm, de préférence à 75 µm.

Selon un mode de réalisation de la présente invention, la deuxième tranche W2 est en silicium ou en verre.

Selon un mode de réalisation de la présente invention, les cavités borgnes sont creusées sur une profondeur de 1 à 5 mm et de préférence de 1,8 à 2 mm.

Selon un mode de réalisation de la présente invention, une gravure mécano-chimique érode la tranche W1 ou la tranche W2.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 illustre un module de capture d'image selon l'art antérieur ;
la figure 2 représente une tranche en matériau semiconducteur dans laquelle sont disposées de nombreuses puces ;
la figure 3 illustre une partie de la structure d'une puce en cours de réalisation ;
la figure 4 illustre un mode de réalisation des passages métalliques ;
la figure 5 représente une deuxième tranche comportant des cavités ;
la figure 6 illustre l'assemblage des première et deuxième tranches ;
les figures 7 à 9 illustrent des étapes successives d'un procédé de réalisation des modules de capture d'images ; et
la figure 10 illustre un module de capture d'images selon un mode de réalisation de l'invention.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

De façon générale, la présente invention prévoit de réaliser un ensemble de modules de capture d'images sur une même tranche avant découpe de cette tranche en modules individuels. Ainsi les procédés d'assemblage des différents modules sont réalisés de manière collective sur la tranche.

La figure 2 représente une tranche W1 en un matériau semiconducteur, par exemple en silicium monocristallin. Cette tranche usuellement utilisée en technologie des semiconducteurs a une épaisseur comprise entre 300 et 1000 µm, de préférence de 500 µm à 750 µm. Le matériau semiconducteur est d'un premier type de conductivité. De nombreuses puces de circuits intégrés sont disposées du côté de la face avant 101 de la tranche W1 dans des zones actives 100. Les zones actives sont séparées par des zones de séparation 102. Des passages métalliques 103 s'enfoncent sous les zones actives 100 à une profondeur comprise entre 50 et 300 µm, de préférence à une profondeur de 75 µm au dessous de la face avant 101 de la tranche W1. La face avant est recouverte par un oxyde 104 d'épaisseur supérieure à 0,05 µm.

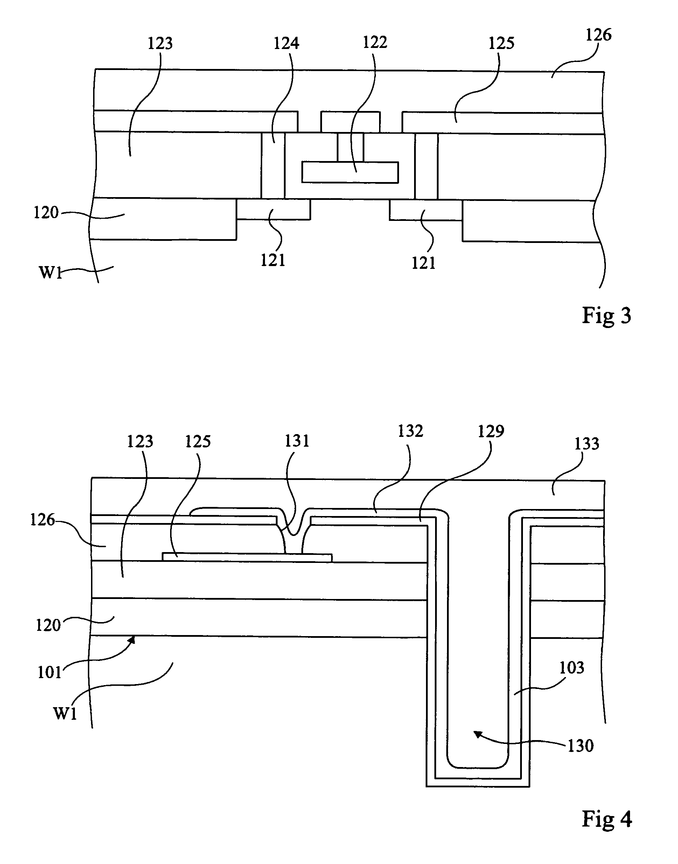

La figure 3 illustre une partie de la structure d'une puce en cours de réalisation. Cette partie comprend un transistor MOS isolé latéralement d'autres composants par un oxyde de champ 120. Le transistor MOS comprend des source et drain 121 dopés du second type et une grille de commande 122 conductrice disposée entre les source et drain et isolée du matériau semiconducteur. Au-dessus des transistors une couche d'isolant 123 est disposée. Des trous de contact 124 comblés par un métal, par exemple du cuivre, sont ouverts dans la couche 123 sur les source, drain et grille des transistors. Un niveau de métallisation 125 par exemple en cuivre connecte électriquement les différents éléments constituant la puce de circuit intégré. Un isolant 126 recouvre l'ensemble des interconnexions.

La figure 4 illustre un mode de réalisation des passages métalliques 103. Les passages métalliques 103 sont formés après le dépôt de la couche isolante 126 recouvrant le premier niveau d'interconnexion 125. Un trou 130 traverse la couche d'isolant 126, la couche d'isolant 123 déposée avant le premier niveau d'interconnexion 125 et l'oxyde de champ 120. Le trou 130 s'enfonce dans la tranche sur une profondeur de plusieurs dizaines de micromètres, par exemple de 10 à 100 µm et de préférence 75 µm au dessous de la surface 101 de la face avant de la tranche W1. Ce trou a une forme sensiblement carrée dont les côtés mesurent plusieurs micromètres, par exemple de 2 à 50 µm, de préférence 10 µm. La gravure s'effectue par exemple en utilisant une gravure plasma à travers un masque dur. Une couche d'isolant 129 déposée sur la tranche, recouvre les parois internes et le fond du trou. Cette couche d'isolant 129 recouvre également l'isolant 126 qui recouvre les interconnexions 125.
Une ouverture de contact 131 effectuée au travers des couches isolantes 126 et 129 dégage localement la surface du niveau métallique 125. Un dépôt métallique gravé 132 recouvre simultanément les ouvertures de contact 131, les parois et le fond du trou 130 mettant ainsi en contact électrique des connexions 125 de la puce avec le passage métallique 103 remplissant le trou 130. Une couche isolante 133 recouvre l'ensemble des interconnexions et comble le vide restant du trou 130. Le passage métallique 103 peut être réalisé de nombreuses façons. En particulier le métal peut être remplacé par un silicium polycristallin fortement conducteur ou par un alliage silicium-métal. La couche de métal 132 peut combler entièrement le trou 130. Enfin, on a représenté le cas où le passage métallique 103 est connecté à une couche d'interconnexion inférieure 125 par l'intermédiaire d'une ouverture de contact 131, déportée latéralement par rapport au trou 130, et du dépôt métallique 132. L'homme de l'art réalisera facilement un contact électrique entre le passage métallique 103 et d'autres niveaux d'interconnexion supérieurs ou inférieurs non représentés. Enfin un mode avantageux consiste à combler le trou 130 par le métal 103 gravé par un polissage mécano-chimique. A travers la couche 133 qui recouvre l'ensemble des interconnexions une ouverture de contact débouchant à la surface du métal 103 ainsi gravé par un polissage mécano-chimique permet de réaliser une connexion électrique au droit du passage métallique 103 avec un niveau de métallisation supérieur non représenté.

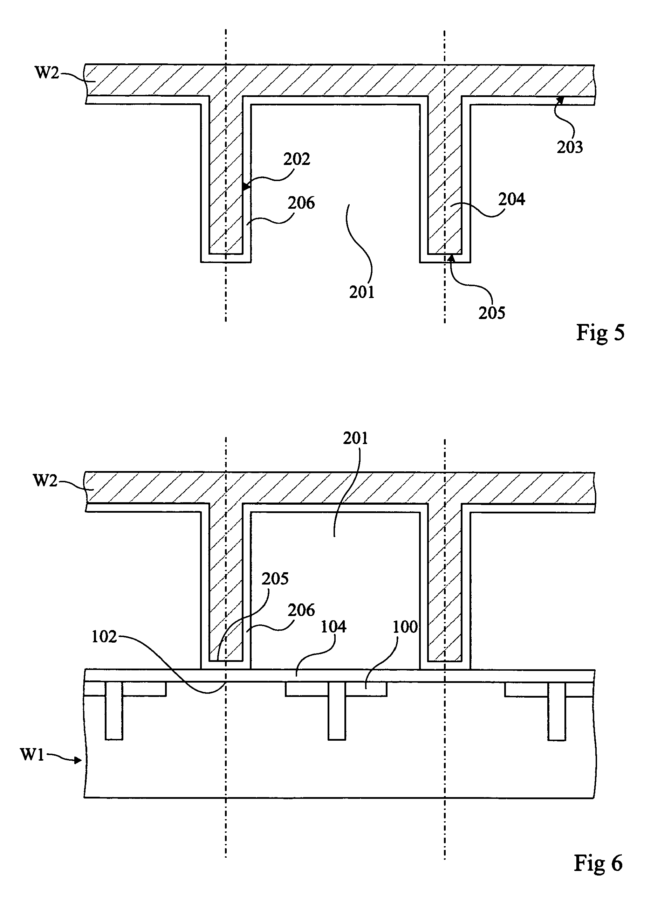

La figure 5 représente une deuxième tranche W2 formée selon un mode de réalisation de silicium polycristallin. La tranche W2 a une épaisseur de plusieurs millimètres par exemple de 1 à 5 mm et de préférence de 1,8 à 2 mm. Des cavités borgnes 201 sont gravées sur une face horizontale de cette tranche W2. De préférence les cavités 201 présentent des flancs 202 verticaux obtenus par une gravure plasma anisotrope. Tout autre profil des flancs 202, selon d'autres modes de réalisation, est réalisable. Par exemple une gravure isotrope des cavités 201 génère un profil convexe. Des profils ondulés ou selon un plan cristallin sont atteignables avec des gravures plasma ou des gravures chimiques en phase aqueuse. Le fond 203 des cavités est plat et parallèle à la face horizontale gravée de la tranche W2. Cette profondeur est comprise entre 0,5 et 4 mm, de préférence 1,7 mm pour une tranche de 1,9 mm d'épaisseur. La précision obtenue pour cette profondeur est meilleure que 100 µm et de préférence meilleure que 10 µm. L'homme de l'art sait réaliser de telles cavités avec des techniques de gravures plasma ou chimiques. La gravure de multiples cavités contigües dans la tranche W2 entraine la création de murs de séparation 204 entre ces cavités. Les sommets 205 de ces murs sont tous dans le même plan et correspondent sensiblement aux zones de séparation 102 situées entre les zones actives 100. La face gravée de la tranche W2 et en particulier les sommets 205 des murs sont recouverts par un oxyde 206 d'épaisseur supérieure à 0,05 µm.

La figure 6 illustre l'assemblage des première W1 et deuxième W2 tranches selon un mode de réalisation. Les zones de séparation 102 de la première tranche W1 et les sommets correspondant 205 des murs de la deuxième tranche W2 sont mis en regard afin que les couches d'oxyde 104 recouvrant la première tranche et 206 recouvrant la deuxième tranche soient en contact. Un collage moléculaire entre les couches d'oxyde 104 et 206 solidarise les tranches W1 et W2. On obtient alors un assemblage dans lequel une cavité 201 est située au dessus de chaque puce.

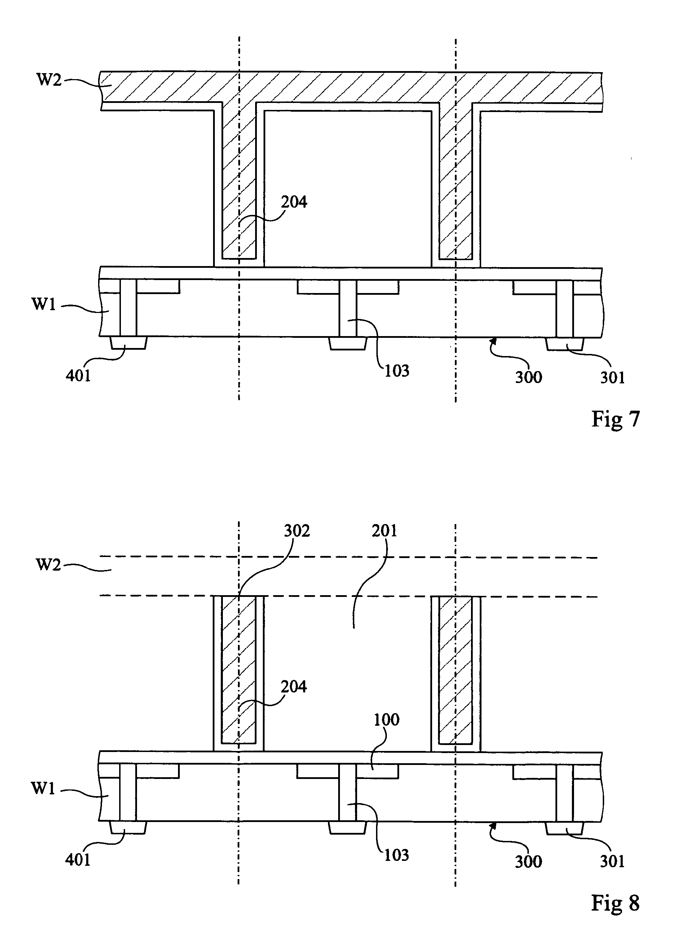

La figure 7 illustre une étape suivante du procédé de réalisation des modules de capture d'images. La face arrière de la tranche W1 est érodée de telle façon que les passages métalliques 103 débouchent sur cette face arrière 300 en des régions 301. Durant cette opération la tranche W1 est maintenue par la poignée constituée par le substrat W2 épais comportant un treillis de murs 204. L'érosion de la face arrière peut s'effectuer par gravure mécano-chimique. Les conditions de gravure changent lorsque le métal du passage métallique 103 apparaît en surface. La gravure est alors arrêtée. L'épaisseur restante de la tranche W1 est alors sensiblement égale à la profondeur des passages métalliques. L'ensemble des tranches W1 et W2 reste mécaniquement rigide notamment à cause de la présence du treillis de murs 204. Des plots de soudure 401 électriquement en contact avec le fond des passages métalliques 103 sont formés sur la face érodée de la tranche W1. Ces plots sont reliés aux connexions électriques de la puce de circuit intégré par les passages métalliques 103. Ils permettent d'effectuer des tests électriques paramétriques et fonctionnels des modules de capture d'images avant toute découpe de la tranche W1.

La figure 8 illustre une étape suivante du procédé de réalisation des modules de capture d'images. La tranche W2 est érodée jusqu'à ouvrir les cavités 201. Le rodage de la deuxième face de la deuxième tranche W2 peut s'effectuer par gravure mécano-chimique. Dès que les cavités 201 sont ouvertes la surface à graver devient réduite, les conditions de gravure changent ce qui permet d'arrêter cette gravure. De la tranche W2 seuls restent les murs arasés selon des surfaces planes 302. La précision de la distance verticale entre ces surfaces planes 302 et les zones actives 100 est celle résultante des différentes gravures des cavités et de l'érosion de la deuxième tranche W2. Cette précision est meilleure que 100 µm et typiquement meilleure que 10 µm. La rigidité de l'ensemble est obtenue par la présence des murs formant un treillis. En conséquence les puces situées dans les zones actives 100 se trouvent entourées de murs 204 dont la hauteur est sensiblement égale à la profondeur initiale des cavités 201 de 1,7 mm dans le cadre de l'exemple donné ci-dessus.

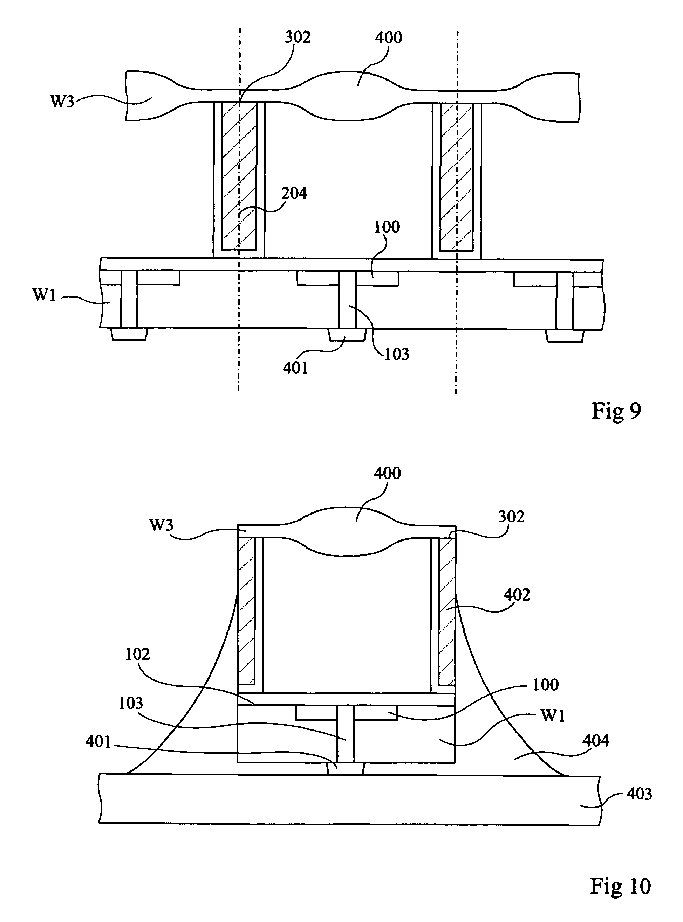

La figure 9 illustre une étape suivante du procédé de réalisation des modules de capture d'images. Une plaque W3 est collée sur la surface plane 302 des murs. Cette plaque est constituée de lentilles optiques 400 réparties de façon à correspondre aux zones actives 100. La plaque W3 est constituée de verre moulée ou de plastique transparent. Selon un mode de réalisation elle est collée avec une colle polyuréthane dispensée localement sur les surfaces planes 302 des murs. Selon un mode de réalisation, le plan focal des lentilles 400 se situe sensiblement à la surface des capteurs d'images des puces situées dans les zones actives 100. Tout autre positionnement du plan focal est possible selon la distance souhaité entre la lentille et les objets dont l'image doit être capturée. L'image obtenue est nette si la précision du positionnement du plan focal est inférieure à 100 µm et de préférence inférieure à 10 µm. La réalisation des murs décrite dans les modes de réalisation proposés de la présente invention permet d'atteindre cette précision sans utiliser aucun moyen spécifique d'ajustement de la distance après le collage de la plaque W3.

Des filtres colorés peuvent avoir été interposés entre la plaque W3 comportant les lentilles 400 et les capteurs d'images.

La figure 10 illustre un module de capture d'images selon un mode de réalisation. La tranche W1, les murs 204, la plaque W3 sont découpés selon les zones de séparation des zones actives 100. Cette découpe est de préférence centrée sur les murs 204 qui sont séparé en deux parties sensiblement égales 402. De multiples moyens sont utilisables pour la découpe. Notamment le laser ou la scie diamantée usuellement employés en technologie des circuits intégrés sont utilisables. On obtient alors un module de capture d'image comportant la puce de circuit intégré située dans la zone active 100, des murs 402 situés à la périphérie de la puce, une lentille de focalisation d'images 400 collée sur le mur périphérique 402. En outre sous ce module de capture d'image débouchent les passages métalliques 103 terminés par des plots de soudure 401. Ce module est représenté soudé sur un circuit imprimé 403. La tenue mécanique du module de capture d'images sur le circuit imprimé est assuré, de préférence, par une colle 404 comblant l'interstice entre la tranche W1 découpée et le circuit imprimé 403. La colle 404 déborde sur le pourtour du module de capture d'images.

Ce module ainsi monté sur le circuit imprimé présente une compacité maximum. La plus grande partie de la surface du module est occupée par la zone active 100. Les zones de séparation 102 entre zones actives sont réduites mais doivent cependant être suffisamment larges pour permettre la découpe des modules de capture d'images. Les murs 402 et la lentille 400 ne débordent pas du chemin de découpe passant par la zone de séparation 102.

Les modes de réalisation particuliers décrits ci-dessus sont susceptibles de nombreuses variantes. La première tranche W1 peut-être mono ou polycristalline. Tout matériau ou alliage apte à détecter des rayonnements lumineux de longueurs d'onde variées est utilisable. Toute technologie associée aux capteurs d'images peut être utilisée, notamment les transistors MOS, FET et bipolaires, les diodes, les CCD (Charge Coupled Devices).

Dans l'exemple illustré ci-dessus le nombre et la position des niveaux d'interconnexions vis-à-vis des passages métalliques 103 sont quelconques. Les niveaux d'interconnexion et en particulier le passage métallique 103 utilise des métaux. Par métaux il faut comprendre tout matériau fortement conducteur de l'électricité comme l'aluminium, le cuivre et leurs alliages mais également le silicium très fortement dopé, les alliages silicium-métal ainsi que, par exemple, toute nanostructure, comme les nanotubes en silicium, fortement conductrice.

Les isolants cités peuvent être des couches composites comportant différents types de matériaux isolants y compris les isolants poreux et l'air.

On a donné ci-dessus plusieurs modes de réalisations pour le passage métallique 103. Les modes de réalisation décrits ne sont pas exhaustifs, par exemple la diffusion de l'aluminium dans du silicium est apte à réaliser de tels passages métalliques. La séquence technologique conduisant à la réalisation du passage métallique peut être modifiée. Par exemple la gravure du trou 130 peut être effectuée après le rodage de la face arrière de la tranche W1 et s'arrêter sur la face arrière de l'interconnexion métallique 125. Le dépôt métallique 132 assure alors un contact électrique avec l'interconnexion 125 comme dans le cas décrit.

Les procédés de gravure et de dépôts sont très variés dans les technologies utilisées en microélectronique. Les procédés cités ci-dessus ne le sont qu'à titre d'exemple. L'homme de l'art saura proposer selon les objectifs à atteindre la meilleure gravure plasma, ionique ou en milieu aqueux avec les composés réactifs correspondants à l'anisotropie ou à la sélectivité nécessaire pour chaque type de gravure.

La deuxième tranche est de préférence en matériau rigide, ayant un coefficient de dilatation similaire au coefficient de dilatation du matériau utilisé pour la première tranche. Le silicium polycristallin convient dans le cas d'une première tranche en silicium car ses propriétés sont stables et connues. Ce choix n'est pas unique on peut en particulier utiliser des matériaux en verre transparent ou des matériaux synthétiques, composites ou des matériaux plastiques pourvu qu'ils puissent être gravés ou moulés, rodés et collés avec les tolérances décrites ci-dessus. Tout système de collage de la deuxième tranche W2 sur la première tranche W1 ou la plaque W3 est réalisable. En particulier on peut dispenser des colles projetées par des buses notamment des colles de type polymère.

La plaque W3 doit être transparente et constituée principalement de lentilles dont les propriétés optiques sont adaptées aux caractéristiques optiques du module de capture d'images. La forme et la complexité de ces lentilles ne sont pas limitées. En particulier des lentilles de Fresnel sont utilisables, un empilement de lentilles peut être utilisé, des couches de protection et d'antireflet peuvent recouvrir les lentilles. La plaque W3 peut être moulée, gravée ou estampée.

## Revendications

1. Procédé de réalisation de modules de capture d'images comportant les étapes successives suivantes :
- réaliser une première tranche (W1) comportant sur une première face (101) des capteurs d'images occupant des zones actives (100) séparées par des zones de séparation (102), des passages conducteurs (103) associés à chaque zone active s'étendant à une certaine profondeur sous la première face (101) de la première tranche (W1) sans la traverser;
- réaliser une deuxième tranche (W2) comportant sur une première face des cavités borgnes (201) entourées de murs (204) correspondants audites zones de séparation (102) ;
- accoler lesdites premières faces des première (W1) et deuxième (W2) tranches en faisant correspondre lesdites zones de séparation (102) audits murs (204) ;
- éroder la première tranche (W1) à partir de sa seconde face jusqu'à atteindre les passages conducteurs (103) ;
- éroder la deuxième tranche (W2) à partir de sa seconde face jusqu'à ouvrir le fond des cavités (201) ;
- coller sur les murs une plaque comportant des lentilles (400) ayant des surfaces correspondant audites zones actives (100) ; et
- découper la structure résultante au niveau des murs (204) afin d'isoler des modules de capture d'images.

2. Procédé selon la revendication 1, dans lequel le capteur d'images est réalisé avec des transistors MOS.

3. Procédé selon la revendication 1 ou 2, dans lequel les passages conducteurs (103) s'étendent à une profondeur de 50 à 300 µm, de préférence à 75 µm.

4. Procédé selon l'une quelconque des revendications 1 à 3, dans lequel la deuxième tranche W2 est en silicium.

5. Procédé selon l'une quelconque des revendications 1 à 3, dans lequel la deuxième tranche W2 est en verre.

6. Procédé selon l'une quelconque des revendications 1 à 5, dans lequel les cavités borgnes sont creusées sur une profondeur de 1 à 5 mm et de préférence de 1,8 à 2 mm.

7. Procédé selon l'une quelconque des revendications 1 à 6, dans lequel l'étape consistant à éroder la première tranche ou à éroder la deuxième tranche est effectuée par gravure mécano-chimique.

## Claims

1. A method for forming image capture units, comprising the successive steps of:
- forming a first wafer (W1) comprising, on a first surface (101), image sensors taking up active areas (100) separated by separation areas (102), conductive passages (103) associated with each active area extending down to a given depth under the first surface (101) of the first wafer (W1) without traversing it;
- forming a second wafer (W2) comprising on a first surface blind cavities (201) surrounded with walls (204) corresponding to said separation areas (102);
- placing said first surfaces of the first (W1) and second (W2) wafers against each other by putting said separation areas (102) in correspondence with said walls (204);
- abrading the first wafer (W1) from its second surface to reach the conductive passages (103);
- abrading the second wafer (W2) from its second surface to open the bottom of the cavities (201);
- gluing on the walls a plate comprising lenses (400) having surfaces corresponding to said active areas (100); and
- cutting the resulting structure at the level of the walls (204) to isolate image capture units.

2. The method of claim 1, wherein the image sensor is formed with MOS transistors.

3. The method of claim 1 or 2, wherein the conductive passages (103) extend down to a depth from 50 to 300 µm, preferably 75 µm.

4. The method of any of claims 1 to 3, wherein second wafer W2 is made of silicon.

5. The method of any of claims 1 to 3, wherein second wafer W2 is made of glass.

6. The method of any of claims 1 to 5, wherein the blind cavities are dug down to a depth from 1 to 5 mm, preferably from 1.8 to 2 mm.

7. The method of any of claims 1 to 6, wherein the step of abrading the first wafer or of abrading the second wafer is implemented by a chem.-mech. etching.

## Patentansprüche

1. Ein Verfahren zur Ausbildung von Bildgebereinheiten, wobei die folgenden aufeinanderfolgenden Schritte vorgesehen sind:
- Bilden eines ersten Wafers (W1), der auf einer ersten Oberfläche (101) Bildsensoren aufweist, die aktive Flächen (100) einnehmen, getrennt durch Trenngebiete (102), leitende Passagen (103) assoziiert mit jeder aktiven Fläche und zwar sich hinab auf eine gegebene Tiefe unter der ersten Oberfläche (101) des ersten Wafers (W1) ohne dessen Durchquerung zu erstrecken;
- Ausbilden eines zweiten Wafers (W2), der auf einer ersten Oberfläche blinde Hohlräume (201) umfasst, und zwar umgeben mit Wänden (204), entsprechend den erwähnten Trenngebieten (102);
- Platzieren der erwähnten ersten Oberflächen des ersten Wafers (W1) und des zweiten Wafers (W2) gegeneinander durch Anordnen der Trenngebiete (102) in Entsprechung mit den Wänden (204);
- Abtragen des ersten Wafers (W1) von seiner zweiten Oberfläche zum Erreichen der leitenden Passagen (103);
- Abtragen des zweiten Wafers (W2) von seiner zweiten Oberfläche zum Öffnen des Bodens der Hohlräume (201);
- Kleben einer Platte auf die Wände, wobei die Platte Linsen (400) aufweist, die Oberflächen besitzen entsprechend den aktiven Flächen (100); und
- Schneiden der sich ergebenden Struktur auf dem Niveau der Wände (204) zur Isolation der Bildgebereinheiten.

2. Verfahren nach Anspruch 1, wobei der Bildsensor mit MOS-Transistoren gebildet wird.

3. Verfahren nach Anspruch 1 oder 2, wobei die leitenden Passagen (103) sich nach unten auf eine Tiefe von 50 bis 300 µm, vorzugsweise von 75 µm, erstrecken.

4. Verfahren nach einem der Ansprüche 1 bis 3, wobei der zweite Wafer (W2) aus Silizium hergestellt ist.

5. Verfahren nach einem der Ansprüche 1 bis 3, wobei der zweite Wafer (W2) aus Glas hergestellt ist.

6. Verfahren nach einem der Ansprüche 1 bis 5, wobei die blinden Hohlräume hinab auf eine Tiefe von 1 bis 5 mm, vorzugsweise von 1,8 bis 2 mm gegraben werden.

7. Verfahren nach einem der Ansprüche 1 bis 6, wobei der Schritt des Abtragens des ersten Wafers oder des Abtragens des zweiten Wafers durch chemisch-mechanisches Ätzen ausgeführt wird.
